# EUROPEAN PATENT SPECIFICATION

(11) **EP 1 865 369 B1**
(45) Date of publication and mention of the grant of the patent: **16.06.2010**
(21) Application number: 07109485.8
(22) Date of filing: 04.06.2007
(51) Int. Cl.: G02F 1/13357, H05B 33/12, H01L 51/52

(54) **Backlight unit and liquid crystal display device including the same**
Rückbeleuchtungseinheit und damit ausgestattete Flüssigkristallanzeige
Unité de rétroéclairage et dispositif d'affichage à cristaux liquides comprenant celle-ci

(30) Priority: 05.06.2006 KR 20060050472
(43) Date of publication of application: 12.12.2007
(73) Proprietor: Samsung Mobile Display Co., Ltd., Suwon-si Gyeonggi-do (KR)
(72) Inventor: Koo, Young-Mo, Gyeonggi-do (KR); Kim, Doo-Hwan, Gyeonggi-do (KR); Jun, Hyuk-Sang, Gyeonggi-do (KR); Kim, Tae-Shick, Gyeonggi-do (KR); Jeong, Hye-In, Gyeonggi-do (KR); Song, Ok-Keun, Gyeonggi-do (KR)
(74) Representative: Hengelhaupt, Jürgen

(56) References cited:
- WO-A-02/37580
- WO-A-98/17083
- JP-A- 7 312 288
- JP-A- 10 189 237
- JP-A- 2003 109 747
- JP-A- 2005 038 767
- US-A1- 2002 033 908

## Description

### CROSS-REFERENCE TO RELATED PATENT APPLICATION

This application claims priority of Korean Patent Application No. 10-2006-0050472, filed on June 5, 2006, in the Korean Intellectual Property Office.

### BACKGROUND OF THE INVENTION

### 1. Field of the Invention

The present invention relates to a backlight unit and a liquid crystal display (LCD) device including the same, and more particularly, to a backlight unit using an organic light emitting element in which brightness can be improved greatly, and an LCD including the backlight unit.

### 2. Description of the Related Art

Recently, organic light emitting elements have been widely used as backlight units of liquid crystal display (LCD) devices.

When an organic light emitting element is used as the backlight of an LCD, a consumption power of the organic light emitting element is greater than, and brightness of the organic light emitting element is lower than, a conventional fluorescent lamp. Thus, it is hard to apply the organic light emitting element to practical devices.

Accordingly, in order to use the organic light emitting element as the backlight unit of the LCD, it is required that the consumption power of the organic light emitting element should be reduced and the brightness of the organic light emitting element should be increased.

Generally, in order to improve the brightness of organic light emitting elements, a light resonance structure is widely used. The light resonance structure should be constructed by finely adjusting an inner distance of the organic light emitting element, that is, a distance between a reflective layer and a semi transport/reflect layer of each layer included in the organic light emitting element, in which resonance occurs.

However, when the inner distances of the light resonance structure are finely adjusted, since each layer of the organic light emitting element is deposited to be a thin layer having a thickness in the order of angstroms through micrometers, a very detailed process is required in reality. Accordingly, manufacture yields decrease and manufacturing costs increase when the desired light resonance is obtained.

JP 10 189237 A discloses a backlight unit comprising a substrate; an organic light emitting element adapted to emit white light formed on the substrate; an encapsulating member attached to the substrate to seal the organic light emitting element; and a scattering film formed on a side at which light emitted by the organic light emitting element is extracted, and formed on the substrate.

WO 02/37580 A discloses a light emitting device which can also be used as a backlight unit comprising: a substrate; an organic light emitting element adapted to emit white light formed on the substrate; and a scattering film formed on a side at which light emitted by the organic light emitting element is extracted, wherein the scattering film comprises a plurality of light diffusing units, wherein the light diffusing units are protruded from a surface of the substrate.

### SUMMARY OF THE INVENTION

The present invention provides a backlight unit using an organic light emitting element in which the efficiency of light extraction is improved without decreasing productivity to achieve high brightness and a low consumption power, and a liquid crystal display (LCD) device including the backlight unit.
According to an aspect of the present invention, there is provided a backlight unit as defined in appended claim 1.
According to the present invention the expression "organic light emitting element emitting white light" or "organic light emitting element adapted to emit white light" shall preferably be an light emitting element on basis of organic light emitting diodes which is adapted to emit light having the different colors (wavelengths) in the same proportion as in the light coming directly from the sun, without having been decomposed, as by passing through a prism. Therefore such light is perceived as white light.
The encapsulating member is preferably made of a transparent material having a refractive index for visible light between 1.4 and 1.8, more preferably encapsulating member is made of glass (such as BK7).
The scattering film may be formed on the surface of the substrate opposite to the surface of the substrate on which the organic light emitting element is formed.

The scattering film may be interposed between the substrate and the organic light emitting element.

The scattering film may be formed between the organic light emitting element and the encapsulating member.

The scattering film may be formed on a surface of the encapsulating member which faces the organic light emitting element.

The backlight unit may further comprise a protective layer formed on the organic light emitting element, wherein the scattering film is formed on the protective layer.

The backlight unit may further comprise a protective layer formed on the organic light emitting element, wherein the scattering film is interposed between the protective layer and the organic light emitting element.

The organic light emitting element may comprise a plurality of pixels.

The organic light emitting element may be a flat luminescence type organic light emitting element.

The organic light emitting element may comprise a single emissive layer emitting white light.

The organic light emitting element may comprise at least two emissive layers for emitting white light.

According to another aspect of the present invention, there is provided a liquid crystal display (LCD) device including: a liquid crystal display panel; and a backlight unit having the above described backlight unit.

### BRIEF DESCRIPTION OF THE DRAWINGS

The above and other features and advantages of the present invention will become more apparent by describing the attached drawings in which:

FIG. 1 is a cross-sectional schematic view of a liquid crystal display (LCD) device using a top emission type organic light emitting display device as a backlight unit useful for understanding the present invention.

FIG. 2 is a cross-sectional schematic view illustrating the case where light is extracted through an encapsulating member and a scattering film of FIG. 1;

FIG. 3 is a cross-sectional view illustrating a scattering film useful for understanding the present invention.

FIG. 4 is a cross-sectional view illustrating a scattering film according to the present invention.

FIG. 5 is a cross-sectional view illustrating a scattering film useful for understanding the present invention.

FIG. 6 is a cross-sectional view illustrating an organic emissive part of FIG. 1.

FIG. 7 is a cross-sectional schematic view of an LCD device using a top emission type organic light emitting display device as a backlight unit useful for understanding the present invention.

FIG. 8 is a cross-sectional view of a protective layer useful for understanding the present invention.

FIG. 9 is a cross-sectional schematic view of an LCD device using a top emission type organic light emitting display device as a backlight unit useful for understanding the present invention.

FIG. 10 is a cross-sectional schematic view of an LCD device using a top emission type organic light emitting display device as a backlight unit useful for understanding the present invention.

FIG. 11 is a cross-sectional schematic view of an LCD device using a bottom emission type organic light emitting display device as a backlight unit useful for understanding the present invention; and

FIG. 12 is a cross-sectional schematic view of an LCD device using a bottom emission type organic light emitting display device as a backlight unit useful for understanding the present invention.

### DETAILED DESCRIPTION OF THE INVENTION

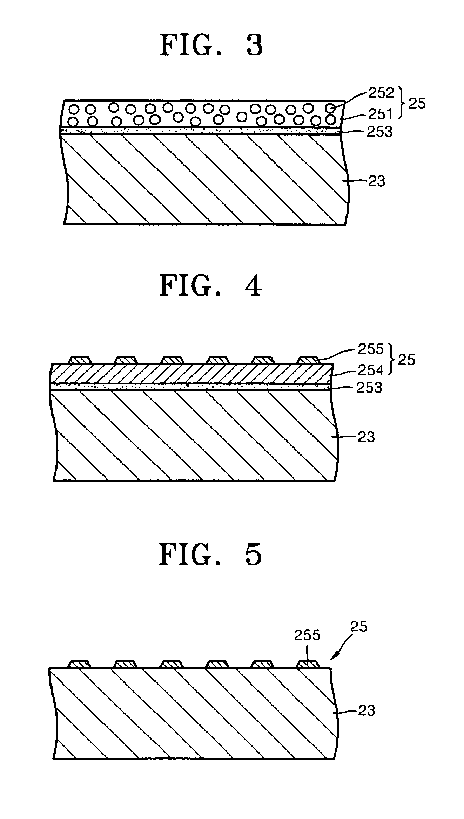

The present invention will now be described more fully with reference to Fig. 4. in which an exemplary embodiment of the invention is shown. The invention may, however, be embodied in many different forms and should not be construed as being limited to embodiment set forth herein; rather, this embodiment is provided so that this disclosure will be thorough and complete, and will fully convey the concept of the invention to those skilled in the art.

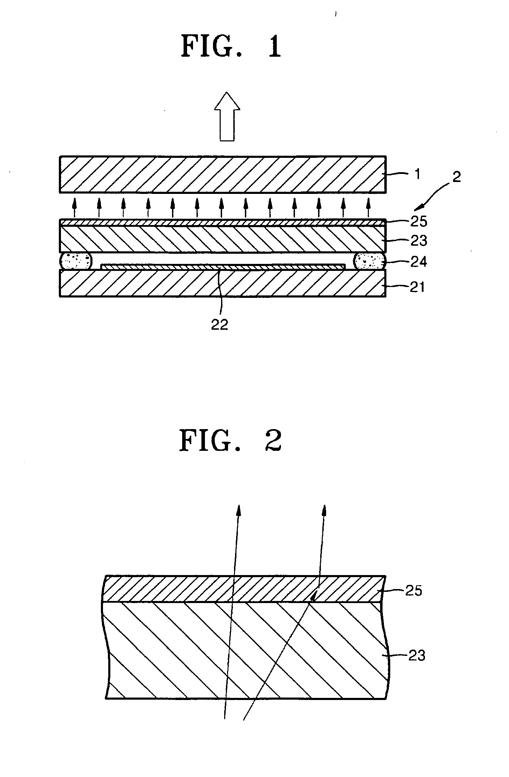

FIG. 1 is a cross-sectional schematic view of a liquid crystal display (LCD) useful for understanding the present invention.

Referring to FIG. 1, the LCD includes a liquid crystal display panel 1 and a backlight unit 2 formed on one side of the liquid crystal display panel 1.

The liquid crystal display panel 1 may be any kind of LCD panel such as TFT LCD, STN LCD, or the like, for example, it may be a mono color LCD or a full color LCD including color filters and a plurality of pixels. The liquid crystal display panel 1 may include at least one polarizer.

Although not illustrated, the LCD may include at least one condenser such as prism sheet formed between the liquid crystal display panel 1 and the backlight unit 2.

The backlight unit 2 includes an organic light emitting element.

The backlight unit 2 includes an organic emissive part 22 which is formed on a substrate 21 and includes an organic light emitting element. The backlight unit 2 has a structure in which an encapsulating member 23 is attached to the substrate 21 in order to seal the organic emissive part 22. Referring to FIG. 1, the encapsulating member 23 may be formed of light transmitting glass or light transmitting plastic. The encapsulating member 23 may be attached to the substrate 21 using sealing adhesive 24 such as sealant, frit, or the like.

The substrate 21 may be a glass substrate formed of SiO₂, but is not limited thereto. That is, the substrate 21 may be formed of plastic, metal, or the like.

The backlight unit 2 may be used in a top emission type organic light emitting display device in which light is extracted through the encapsulating member 23.

The backlight unit 2 includes a scattering film 25 formed on the encapsulating member 23 through which light is extracted.

The scattering film 25 prevents light, which is transmitted and extracted through the encapsulating member 23, from totally-reflecting on an external surface of the encapsulating member 23.

That is, when light which is generated in the backlight unit 2 is transmitted and extracted through the encapsulating member 23, a total reflection occurs on the external surface of the encapsulating member 23 due to the difference of refraction index between the encapsulating member 23 and air.
The scattering film 25 formed on the encapsulating member 23 allows light, which is totally reflected on an interface between the encapsulating member 23 and air, to instead be transmitted. As illustrated in FIG. 2, the scattering film 25 prevents light transmitted from the encapsulating member 23 from being totally reflected in order to allow light to be transmitted out of the backlight unit 2. Accordingly, the efficiency of light extraction can be remarkably improved, and a high brightness and a low consumption of electric power can be achieved.

The scattering film 25 may be formed of any material which inhibits reflection of light to improve brightness.

FIG. 3 is a cross-sectional view illustrating a scattering film 25 useful for understanding the present invention. Referring to FIG. 3, the scattering film 25 is a separate sheet and it is attached to an encapsulating member 23 by a transparent adhesive layer 253.

The scattering film 25 may include a transparent resin layer 251 and a plurality of scattering particles 252 inherently present in the transparent resin layer 251.

The transparent resin layer 251 may be formed of materials selected from the group consisting of styrene resins, acrylic resins, vinyl ester resins, vinyl ether resins, halogen containing resins, olefin resins, polyphenylenether resins, polyphenylene sulfide resins, cellulose derivatives, silicon resins, rubbers, elastomers, combinations thereof, or the like.

Each diffusing particle 252 may be a light reflective metal corpuscle such as aluminum, silver, gold, or the like, but is not limited thereto. That is, the diffusing particle 252 may be any material having a refractive index different from that of the transparent resin layer 251.

In the scattering film 25, it can be seen that the amount of light which is emitted perpendicular to the top surface of the scattering film 25 is greater than the amount of light that is emitted in a direction at an angle to the surface of the scattering film 25. Accordingly, light directing toward the liquid crystal display panel 1 can be greatly increased.

FIG. 4 is a cross-sectional view illustrating a scattering film 25 according to the present invention. Referring to FIG. 4, the scattering film 25 is a separate sheet and it is attached to an encapsulating member 23 by a transparent adhesive layer 253.

The scattering film 25 may be formed to have a structure in which a plurality of light diffusing patterns 255 are printed or coated on a transparent base film 254.

The transparent base film 254 may be formed of transparent resin materials selected from the group consisting of styrene resins, acrylic resins, vinyl ester resins, vinyl ether resins, halogen containing resins, olefin resins, polyphenylenether resins, polyphenylene sulfide resins, cellulose derivatives, silicon resins, rubbers, elastomers, combinations thereof, or the like.

The light diffusing patterns 255 are formed by printing white pigments on the transparent base film 254, or alternatively, they are formed by coating a light reflective metal such as aluminum, silver, gold, or the like to have a predetermined pattern.

FIG. 5 is a cross-sectional view illustrating a scattering film 25 useful for understanding the present invention. Referring to FIG. 5, the scattering film 25 is formed by directly painting or coating a plurality of light diffusing patterns 255 on an encapsulating member 23.

Referring to FIGS. 4 and 5, the scattering film 25 having the light diffusing pattern 255 prevents light, which is transmitted through the encapsulating member 23 in a direction at an angle to the top surface of the encapsulating member 23, from being totally reflected, and thus, it can greatly improve brightness by diffusing light.

Meanwhile, the organic emissive part 22 illustrated in FIG. 1 may be an organic light emitting element emitting white light.

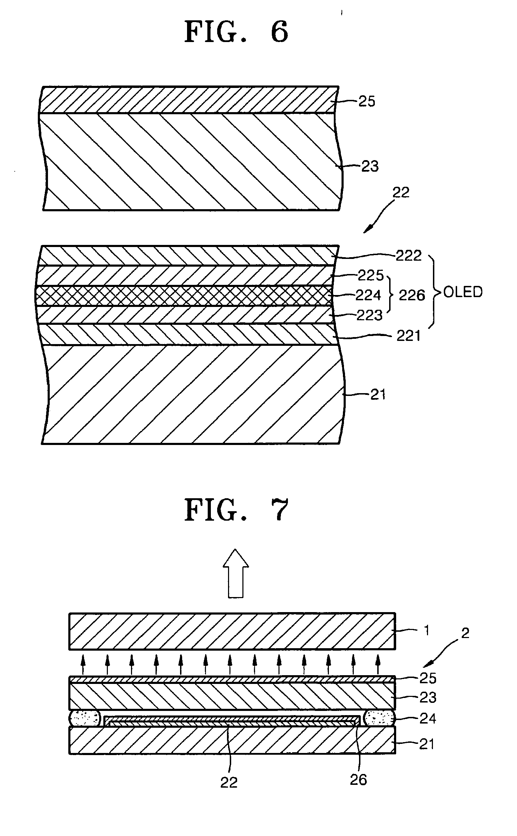

FIG. 6 is a cross-sectional view illustrating the organic emissive part 22 of FIG. 1. Referring to FIG. 6, the organic emissive part 22 includes an organic light emitting element including a first electrode 221 formed on a substrate 21, a second electrode 222 opposite to the first electrode 221, and organic layers 226 interposed between the first electrode 221 and the second electrode 222.

The first electrode 221 and the second electrode 222 may function as anode and cathode electrodes, respectively, or vice versa.

When the first electrode 221 functions as the anode electrode, it includes a conductor having a high work function. When the first electrode 221 functions as the cathode electrode, it includes a conductor having a low work function. When the second electrode 222 functions as the cathode electrode, it includes a conductor having a low work function. When the second electrode 222 functions as the anode electrode, it includes a conductor having a high low work function. The conductor having a high work function may be formed of transparent conductive oxides such as ITO, ln203, ZnO, IZO, or the like, and noble metals such as Au, or the like. The conductor having a low work function may be formed of Ag, Al, Mg, Li, Ca, LiF/Ca, LiF/Al, or the like.

In the top emission type organic light emitting display device as illustrated in FIGS. 1 and 6, the first electrode 221 includes a light reflector, and the second electrode 222 is a light transmitting type electrode.

Accordingly, when the first electrode 221 functions as the anode electrode, the light reflector is formed of at least on selected from the group of Ag, Mg, Al, Pt, Pd, Au, Ni, Nd, Ir, Cr, and compounds thereof, or the like. A conductor such as ITO, IZO, ZnO, ln203, compounds thereof, or the like is formed to be a layer on the reflector. When the first electrode 221 functions as the cathode electrode, it is formed of Ag, Al, Mg, Li, Ca, LiF/Ca, LiF/Al, or the like which has a low work function and which is reflective to light.

When the second electrode 222 functions as the cathode electrode, it is formed as a thin layer and formed of metals such as Li, Ca, LiF/Ca, LiF/Al, Al, Mg, Ag, or the like having a low work function to be a metal semi-transmitting layer. A transparent conductor such as ITO, IZO, ZnO, or ln203 is formed on the metal semi-transmitting layer, and thus, a high resistance due to a thin thickness can be overcome. When the second electrode 222 functions as the anode electrode, it can be formed of ITO, IZO, ZnO, In2O3, compounds thereof, or the like and is formed to be a layer.

Organic layers 226 facilitate the flow of holes and electrons generated from the anode and cathode electrodes. When the first electrode 221 functions the anode electrode, the first organic layer 223 is a hole injection/transport layer, and the second organic layer 225 is an electron injection/transport layer. When the first electrode 221 functions the cathode electrode, the first organic layer 223 is an electron injection/transport layer, and the second organic layer 225 is a hole injection/transport layer.

The organic layer 224 may be formed of a single white light emitting organic compound, or alternatively, it may be formed by stacking at least two organic emissive layers having a different color from each other to achieve white light emission.

When the organic layer 224 is formed by stacking at least two organic emissive layers, a red emissive layer, a green emissive layer, and a blue emissive layer are stacked sequentially to form the emissive layer 224, or alternatively, a sky blue layer is formed on a red-green mixed layer to form the emissive layer 224.

In addition, the white light emission can be achieved using various methods.

The organic light emitting element may be a device having a passive matrix (PX) type or an active matrix (AM) type.

Structures having the PX type and the AM type can be selected using any conventional structure.

The organic light emitting element may comprise a plurality of pixels, but the structure of the organic light emitting element is not limited thereto. That is, the organic light emitting element may be a flat emitting type organic light emitting element having a single pixel.

When the organic emissive part has a plurality of pixels, each pixel of the organic emissive part is arranged to a corresponding pixel of the liquid crystal display panel 1.

As illustrated in FIG. 7, the organic emissive part 22 including the organic light emitting element may be covered with a protective layer 26.

The protective layer 26 is formed on the organic emissive part 22 to be a layer, and it protects the organic emissive part 22 including the organic light emitting element from oxygen and humidity.

The protective layer 26 may be formed of transparent inorganic and/or organic compounds.

The inorganic compounds may be metal oxide, metal nitride, metal carbide, metal oxynitride or compounds thereof. Metal oxide may be silicon oxide, aluminum oxide, titanium oxide, indium oxide, tin oxide, indium tin oxide or compounds thereof. Metal nitride may be aluminum nitride, silicon nitride or compounds thereof. Metal carbide may be silicon carbide. Metal oxynitride may be silicon oxynitride. In addition, inorganic compounds may be silicon, and ceramic derivatives of each of silicon and metal, or alternatively, diamond-like carbon (DLC), or the like.

Organic compounds may be an organic polymer, inorganic polymers, organometallic polymers, hybrid organic/inorganic polymers, or the like, or alternatively, acryl resins.

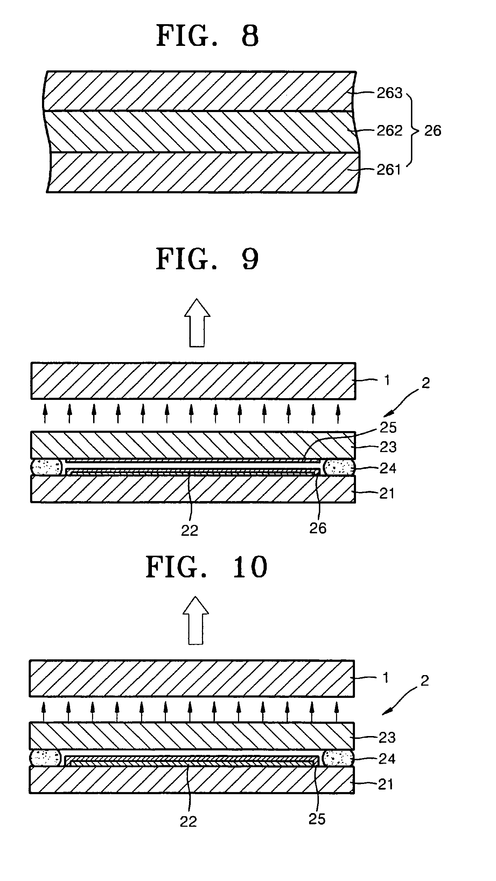

As illustrated in FIG. 8, inorganic layers 261 and 263 and an organic layer 262 are alternately stacked to form the protective layer 26. A stacking order of the inorganic layers 261 and 263 and the organic layer 262 is not limited to the structure of the protective layer 26 shown in FIG. 8. That is, an organic layer, an inorganic layer and an organic layer may be stacked sequentially. A stacking structure is not limited to a structure having three layers as in the protective layer 26 shown in FIG. 8. That is, a plurality of layers may be stacked to form the protective layer 26.

The above described structures of the protective layer 26 can be used in the embodiment of the present invention.

As illustrated in FIGS. 1 and 7, a space is formed between the organic emissive part 22 and the encapsulating member 23. That is, resins such as acryl, inert gases, or the like may fill a space formed between the organic emissive part 22 and the encapsulating member 23. A moisture absorbent may fill the space formed between the organic emissive part 22 and the encapsulating member 23.

FIG. 9 is a cross-sectional view of an LCD device using a top emission type organic light emitting display device as a backlight unit useful for understanding the present invention. Referring to FIG. 9, in a backlight unit 2 including the top emission type organic light emitting display device, a scattering film 25 is formed between an encapsulating member 23 and an organic emissive part 22. In particular, the scattering film 25 is formed on an inner surface, that is, it is formed on a surface being toward the organic emissive part 22 of the encapsulating member 23. As illustrated in FIG. 10, the scattering film 25 may be formed to cover the organic emissive part 22.

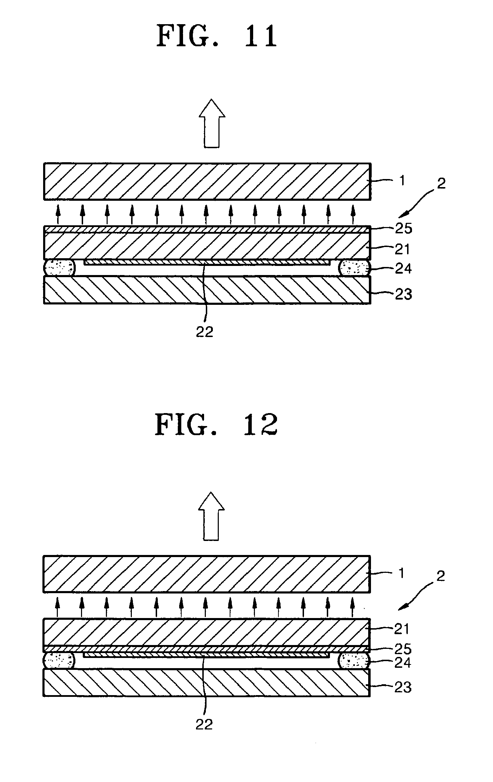

FIGS. 11 and 12 are cross-sectional views illustrating LCD devices, and they illustrate the case where a bottom emission type organic light emitting display device, in which light is emitted toward the substrate 21, can be used in a backlight unit 2.

As illustrated in FIG. 11, a scattering film 25 is formed on an outer surface of a substrate 21, that is, it is formed on a surface of the substrate 21facing a liquid crystal display panel 1. As illustrated in FIG. 12, a scattering film 25 is formed on an inner surface of a substrate 21, that is, it is formed between the substrate 21 and an organic emissive part 22.

As described above, the present invention can achieve the following.

First, a scattering film prevents a total reflection of light output incident at an angle to the surface of the scattering film , and thus improves brightness due to diffusing of light.

Second, a backlight unit having high brightness can be provided.

Third, an organic light emitting display device having low enough consumption of electric power can be used in a backlight unit.

While the present invention has been particularly shown and described with reference to an exemplary embodiment thereof, it will be understood by those of ordinary skill in the art that various changes in form and details may be made therein without departing from the scope of the present invention as defined by the following claims.

## Claims

1. A backlight unit comprising:
a substrate (21);
an organic light emitting element (22) adapted to emit white light and formed on the substrate (21);
an encapsulating member (23) attached to the substrate (21) to seal the organic light emitting element (22); and
a scattering film (25) adapted to prevent total internal reflection of light of the organic light emitting element (22) at the surface on which the scattering film (25) is formed, the scattering film (25) being formed on the side relative to the organic light emitting element (22) at which light emitted by the organic light emitting element (22) is extracted from the backlight unit, and formed on one surface of the substrate (21) or of the organic light emitting element (22) or of the encapsulating member (23),
wherein the scattering film (25) comprises a transparent base film (254) and a plurality of light diffusing units (255)
wherein the light diffusing units (255) are separated from each other along an axis which is parallel to the top surface of the transparent base film (254), and the light diffusing units (255) are arranged to form a regular pattern,
**characterized in that** the light diffusing units (255) are arranged on the surface of the transparent base film (254) which faces away from said one surface of the substrate (21) or of the organic light emitting element (22) or of the encapsulating member (23), and are protruded from said surface of the transparent base film (254),
and **in that** the light diffusing units (255) are formed of white pigments or of light reflective and light scattering metal particles selected from the group consisting of aluminum, silver and gold.

2. The backlight unit of claim 1, wherein the scattering film (25) is formed on the surface of the substrate (21) opposite to the surface of the substrate (21) on which the organic light emitting element (22) is formed.

3. The backlight unit of claim 1, wherein the scattering film (25) is interposed between the substrate (21) and the organic light emitting element (22).

4. The backlight unit of claim 1, wherein the scattering film (25) is formed between the organic light emitting element (22) and the encapsulating member (23).

5. The backlight unit according to claim 4, wherein the scattering film (25) is formed on the surface of the encapsulating member (23) which faces the organic light emitting element (22).

6. The backlight unit according to one of the claims 1 and 4, further comprising a protective layer (26) formed on the organic light emitting element (22),
wherein the scattering film (25) is formed on the protective layer (26).

7. The backlight unit according to one of the claims 1 and 4, further comprising a protective layer (26) formed on the organic light emitting element (22),
wherein the scattering film (25) is interposed between the protective layer (26) and the organic light emitting element (22).

8. The backlight unit according to one of the claim 1, wherein the scattering film (25) is formed on an outer surface of the encapsulating member (23).

9. The backlight unit according to one of the preceding claims, wherein the organic light emitting element (22) comprises a plurality of pixels and/or wherein the organic light emitting element (22) is a flat luminescence type organic light emitting element.

10. The backlight unit according to one of the preceding claims, wherein the organic light emitting element (22) comprises a single emissive layer adapted to emit white light or wherein the organic light emitting element (22) comprises at least two emissive layers adapted to emit white light.

11. The backlight unit according to one of the preceding claims, wherein the transparent base film (254) is formed of a material selected from the group consisting of styrene resins, acrylic resins, vinyl ester resins, vinyl ether resins, halogen containing resins, olefin resins, polyphenylenether resins, polyphenylene sulfide resins, cellulose derivatives, silicon resins, rubbers, elastomers and combinations thereof.

12. A liquid crystal display (LCD) device comprising:
a liquid crystal display panel (1); and
a backlight unit (2) according to one of the claims 1-11.

## Patentansprüche

1. Hintergrundbeleuchtungseinheit, aufweisend:
ein Substrat (21);
ein organisches lichtemittierendes Element (22), das zur Emission von weißem Licht ausgebildet ist und auf dem Substrat (21) ausgebildet ist;
ein Verkapselungselement (23), das am Substrat (21) befestigt ist, so dass das organische lichtemittierende Element (22) abgedichtet wird; und
einen Streufilm (25), der ausgebildet ist, die Totalreflexion von Licht des organischen lichtemittierenden Elements (22) an der Oberfläche, auf der der Streufilm (25) ausgebildet ist, zu verhindern, wobei der Streufilm (25) auf der Seite relativ zum organischen lichtemittierenden Element (22) ausgebildet ist, auf der Licht, das vom organischen lichtemittierenden Element (22) emittiert wird, von der Hintergrundbeleuchtungseinheit extrahiert wird, und auf einer Oberfläche des Substrats (21) oder des organischen lichtemittierenden Elements (22) oder des Verkapselungselements (23) ausgebildet ist,
wobei der Streufilm (25) einen transparenten Trägerfilm (254) und eine Vielzahl lichtstreuender Einheiten (255) aufweist,
wobei die lichtstreuenden Einheiten (255) entlang einer Achse, die parallel zur Oberseite des transparenten Trägerfilms (254) ist, voneinander getrennt sind, und wobei die lichtstreuenden Einheiten (255) derart angeordnet sind, dass sie ein regelmäßiges Muster ausbilden,
**dadurch gekennzeichnet, dass** die lichtstreuenden Einheiten (255) auf der von der besagten einen Oberfläche des Substrats (21) oder des organischen lichtemittierenden Elements (22) oder des Verkapselungselements (23) abgewandten Oberfläche des transparenten Trägerfilms (254) angeordnet sind und aus der besagten Oberfläche des transparenten Trägerfilms (254) hervorragen,
und **dadurch**, dass die lichtstreuenden Einheiten (255) aus weißen Pigmenten oder aus lichtreflektierenden und lichtstreuenden Metallpartikeln, die aus der Gruppe bestehend aus Aluminium, Silber und Gold ausgewählt sind, ausgebildet sind.

2. Hintergrundbeleuchtungseinheit nach Anspruch 1, wobei der Streufilm (25) auf der Oberfläche des Substrats (21) ausgebildet ist, die der Oberfläche des Substrats (21), auf der das organische lichtemittierende Element (22) ausgebildet ist, gegenüberliegt.

3. Hintergrundbeleuchtungseinheit nach Anspruch 1, wobei der Streufilm (25) zwischen dem Substrat (21) und dem organischen lichtemittierenden Element (22) angeordnet ist.

4. Hintergrundbeleuchtungseinheit nach Anspruch 1, wobei der Streufilm (25) zwischen dem organischen lichtemittierenden Element (22) und dem Verkapselungselement (23) ausgebildet ist.

5. Hintergrundbeleuchtungseinheit nach Anspruch 4, wobei der Streufilm (25) auf der Oberfläche des Verkapselungselements (23) ausgebildet ist, die dem organischen lichtemittierenden Element (22) zugewandt ist.

6. Hintergrundbeleuchtungseinheit nach einem der Ansprüche 1 und 4, weiterhin aufweisend eine Schutzschicht (26), die auf dem organischen lichtemittierenden Element (22) ausgebildet ist, wobei der Streufilm (25) auf der Schutzschicht (26) ausgebildet ist.

7. Hintergrundbeleuchtungseinheit nach einem der Ansprüche 1 und 4, weiterhin aufweisend eine Schutzschicht (26), die auf dem organischen lichtemittierenden Element (22) ausgebildet ist, wobei der Streufilm (25) zwischen der Schutzschicht (26) und dem organischen lichtemittierenden Element (22) angeordnet ist.

8. Hintergrundbeleuchtungseinheit nach Anspruch 1, wobei der Streufilm (25) auf einer Außenfläche des Verkapselungselements (23) ausgebildet ist.

9. Hintergrundbeleuchtungseinheit nach einem der vorhergehenden Ansprüche, wobei das organische lichtemittierende Element (22) eine Vielzahl von Pixeln aufweist und/oder wobei das organische lichtemittierende Element (22) ein organisches lichtemittierendes Element vom Flachlumineszenztyp ist.

10. Hintergrundbeleuchtungseinheit nach einem der vorhergehenden Ansprüche, wobei das organische lichtemittierende Element (22) eine einzelne Emissionsschicht aufweist, die zur Emission von weißem Licht ausgebildet ist, oder wobei das organische lichtemittierende Element (22) zumindest zwei Emissionsschichten aufweist, die zur Emission von weißem Licht ausgebildet sind.

11. Hintergrundbeleuchtungseinheit nach einem der vorhergehenden Ansprüche, wobei der transparente Trägerfilm (254) aus einem Material ausgebildet ist, das aus der Gruppe bestehend aus Styrolharzen, Acrylharzen, Vinylesterharzen, Vinyletherharzen, halogenhaltigen Harzen, Olefinharzen, Polyphenylenetherharzen, Polyphenylensulfidharzen, Cellulosederivaten, Siliconharzen, Gummis, Elastomeren und Kombinationen derselben ausgewählt ist.

12. Flüssigkristallanzeige (LCD), aufweisend:
eine Flüssigkristallanzeigetafel (1); und
eine Hintergrundbeleuchtungseinheit (2) gemäß einem der Ansprüche 1 bis 11.

## Revendications

1. Unité de rétro-éclairage comprenant :
un substrat (21) ;
un élément organique d'émission de lumière (22) adapté pour émettre de la lumière blanche, et formé sur le substrat (21) ;
un élément d'encapsulation (23) attaché au substrat (21) afin de sceller l'élément organique d'émission de lumière (22) ; et
un film de dispersion (25) adapté pour prévenir une réflexion interne totale de lumière de l'élément organique d'émission de lumière (22) au niveau de la surface sur laquelle le film de dispersion (25) est formé, le film de dispersion (25) étant formé sur le côté par rapport à l'élément organique d'émission de lumière (22) au niveau duquel de la lumière émise par l'élément organique d'émission de lumière (22) est extraite de l'unité de rétro-éclairage, et formé sur une surface du substrat (21),
ou de l'élément organique d'émission de lumière (22) ou de l'élément d'encapsulation (23),
où le film de dispersion (25) comprend un film de base transparent (254) et une pluralité d'unités de diffusion de lumière (255),
où les unités de diffusion de lumière (255) sont séparées les unes des autres le long d'un axe qui est parallèle à la surface supérieure du film de base transparent (254), et les unités de diffusion de lumière (255) sont agencées de manière à former un motif régulier,
**caractérisée en ce que** les unités de diffusion de lumière (255) sont agencées sur la surface du film de base transparent (254) qui tourne le dos à ladite une surface du substrat (21), ou de l'élément organique d'émission de lumière (22) ou de l'élément d'encapsulation (23) et font saillie de ladite surface du film de base transparent (254),
et **en ce que** les unités de diffusion de lumière (255) sont formées de pigments blancs ou de particules métalliques réfléchissant la lumière ou dispersant la lumière sélectionnées du groupe constitué d'aluminium, d'argent et d'or.

2. Unité de rétro-éclairage de la revendication 1, dans laquelle le film de dispersion (25) est formé sur la surface du substrat (21) opposée à la surface du substrat (21) sur laquelle l'élément organique d'émission de lumière (22) est formé.

3. Unité de rétro-éclairage de la revendication 1, dans laquelle le film de dispersion (25) est interposé entre le substrat (21) et l'élément organique d'émission de lumière (22).

4. Unité de rétro-éclairage de la revendication 1, dans laquelle le film de dispersion (25) est formé entre l'élément organique d'émission de lumière (22) et l'élément d'encapsulation (23).

5. Unité de rétro-éclairage selon la revendication 4, dans laquelle le film de dispersion (25) est formé sur la surface de l'élément d'encapsulation (23) qui est en vis-à-vis de l'élément organique d'émission de lumière (22).

6. Unité de rétro-éclairage selon l'une des revendications 1 et 4, comprenant en outre une couche de protection (26) formée sur l'élément organique d'émission de lumière (22), dans laquelle le film de dispersion (25) est formé sur la couche de protection (26).

7. Unité de rétro-éclairage selon l'une des revendications 1 et 4, comprenant en outre une couche de protection (26) formée sur l'élément organique d'émission de lumière (22), dans laquelle le film de dispersion (25) est interposé entre la couche de protection (26) et l'élément organique d'émission de lumière (22).

8. Unité de rétro-éclairage selon la revendication 1, dans laquelle le film de dispersion (25) est formé sur une surface externe de l'élément d'encapsulation (23).

9. Unité de rétro-éclairage selon l'une des revendications précédentes, dans laquelle l'élément organique d'émission de lumière (22) comprend une pluralité de pixels et/ou dans laquelle l'élément organique d'émission de lumière (22) est un élément organique d'émission de lumière du type luminescent plat.

10. Unité de rétro-éclairage selon l'une des revendications précédentes, dans laquelle l'élément organique d'émission de lumière (22) comprend une seule couche d'émission adaptée pour émettre de la lumière blanche ou dans laquelle l'élément organique d'émission de lumière (22) comprend au moins deux couches d'émission adaptées pour émettre de la lumière blanche.

11. Unité de rétro-éclairage selon l'une des revendications précédentes, dans laquelle le film de base transparent (254) est formé d'un matériau sélectionné du groupe constitué de résines de styrène, résines acryliques, résines d'ester vinylique, résines d'éther vinylique, résines contenant un halogène, résines oléfiniques, résines de poly(phénylène éther), résines en sulfure de polyphénylène, dérivés cellulosiques, résines de silicium, caoutchoucs, élastomères et leurs combinaisons.

12. Dispositif d'affichage à cristaux liquides (LCD) comprenant :
un panneau d'affichage à cristaux liquides (1) ; et
une unité de rétro-éclairage (2) selon l'une des revendications 1-11.
